(19) Europäisches Patentamt
European Patent Office
Office européen des brevets

(11) **EP 4 738 011 A1**

(12) **EUROPEAN PATENT APPLICATION**

(43) Date of publication:
06.05.2026 Bulletin 2026/19

(21) Application number: 24209340.9

(22) Date of filing: **29.10.2024**

(51) International Patent Classification (IPC):
*G03F 7/20* (2006.01)   *G03F 7/00* (2006.01)

(52) Cooperative Patent Classification (CPC):
**G03F 7/70758; G03F 7/70725; G03F 7/70766**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: ASML Netherlands B.V.
5500 AH Veldhoven (NL)

(72) Inventors:
• **VAN DRENT, William, Peter**
  **5500 AH Veldhoven (NL)**
• **KOEVOETS, Adrianus, Hendrik**
  **5500 AH Veldhoven (NL)**

(74) Representative: **ASML Netherlands B.V.**
**Corporate Intellectual Property**
**P.O. Box 324**
**5500 AH Veldhoven (NL)**

Remarks:
Claims .16-18 are deemed to be abandoned due to non-payment of the claims fees (Rule 45(3) EPC).

(54) **POSITIONING SYSTEM, LITHOGRAPHIC APPARATUS, METHOD TO DRIVE A MOVABLE SUPPORT OF A POSITIONING SYSTEM AND METHOD COMPRISING A PATTERNED RADIATION BEAM ONTO A SUBSTRATE**

(57)    The invention provides a positioning system for positioning an object. The positioning system comprises a movable support (PW) to support the object (W), one or more actuators (MAC) to exert a driving force on the movable support (PW), a control system to control the one or more actuators to move the movable support towards a desired position, and a potential energy release device (PER) connected to the movable support (PW) and configured to release potential energy during acceleration of the movable support (PW) to increase acceleration of the movable support body.

**Fig. 3**

## Description

The present disclosure relates to a positioning system for positioning an object. The disclosure further relates to a lithographic apparatus comprising such positioning system, a method to drive a movable support of a positioning system and a method comprising projecting a patterned radiation beam onto a substrate.

## BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

In known embodiments of a lithographic apparatus, positioning systems are used to position an object, for example a patterning device or a substrate, in a desired position. These positioning systems comprise an actuator assembly, comprising one or more actuators, for example electro-magnetic motors, and are configured to accelerate the object with large accelerations and position the object with high positioning accuracy. With increasing demands on overlay and throughput performance, there is however a continuous need to increase acceleration and positioning accuracy of the positioning systems in the lithographic apparatus.

In practice, there may be a limit on the acceleration that can be provided by electro-magnetic motors. Increased acceleration would typically need more space for coils and/or magnets of the actuator assembly. This space is not always available. Furthermore, increased acceleration also requires substantial additional costs in required electrical power.

## SUMMARY

It is an object to provide a positioning system for positioning an object, for example a positioning system of a lithographic apparatus, that enables increased acceleration of an object supported by the positioning system. It is another object to provide a method to drive a movable support of a positioning system that allows increased acceleration of the movable support.

According to an embodiment, there is disclosed a positioning system for positioning an object, the positioning system comprising:

> a movable support to support the object,
> one or more actuators, for example electromagnetic actuators, to exert a driving force on the movable support,
> a control system to control the one or more actuators to move the movable support towards a desired position, and
> a potential energy release device connected to the movable support and configured to release potential energy during acceleration of the movable support to increase acceleration of the movable support body.

According to an embodiment, there is disclosed a lithographic apparatus comprising such positioning system.

According to an embodiment, there is disclosed a method to drive a movable support of a positioning system, wherein the method comprises accelerating the movable support by:

> exerting a potential energy based driving force on the movable support using a potential energy release device, and
> simultaneously exerting an actuator based driving force on the movable support using one or more actuators.

According to an embodiment, there is disclosed a method comprising projecting a patterned radiation beam onto a substrate, the method comprising

> supporting the substrate by the movable support of the positioning system of any of the claims 1-12,
> moving the movable support during a scanning movement in a scanning direction to project the patterned radiation beam onto a first exposure field of the substrate,
> moving the movable support during a step movement between two scanning movements in a step direction to align the patterned radiation beam with a second exposure field of the substrate, which second exposure field is spaced from the first exposure field in the step direction, wherein the method further comprises:

> releasing potential energy stored in the potential energy release device for acceleration of the movable support in the scanning direction during beginning of the scanning movement of the movable support, or
> releasing potential energy stored in the potential energy release device for acceleration of the movable support in the step direction during beginning of the step movement of the movable support.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a detailed view of a part of the lithographic apparatus of Fig. 1;
- Figure 3 schematically depicts a cross-section of an embodiment of a potential energy release device with a movable mass in a neutral position;
- Figure 4 schematically depicts the potential energy release device of Fig. 3 with the movable mass in a first end position;
- Figure 5 schematically depicts the potential energy release device of Fig. 3 with the movable mass in a second end position;
- Figure 6 schematically depicts scanning and step movements of a substrate with respect to a patterned radiation beam during a lithographic process;
- Figure 7 schematically depicts an arrangement of potential energy release devices on an actuator assembly of a long-stroke module of a positioning system of a lithographic apparatus; and
- Figure 8 schematically depicts a cross-section of an alternative embodiment of a potential energy release device.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

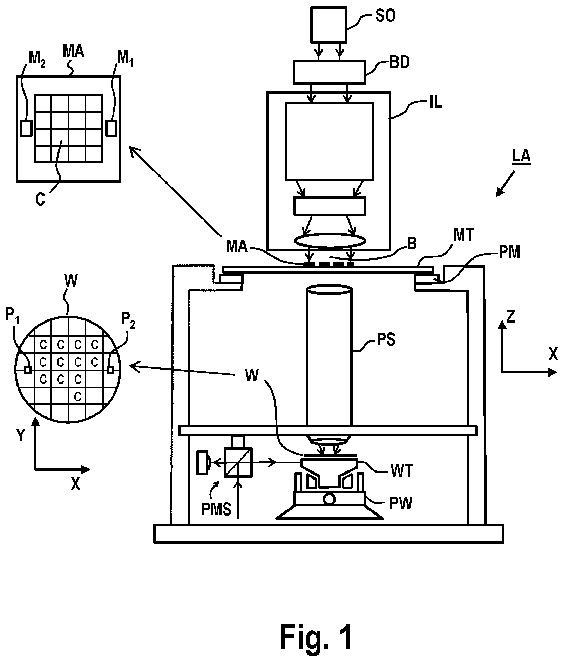

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the patterning device MA, the radiation beam B passes through the projection system PS, which focuses the beam onto a target portion C of the substrate W. With the aid of the second positioner PW and a position measurement system PMS, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axis, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

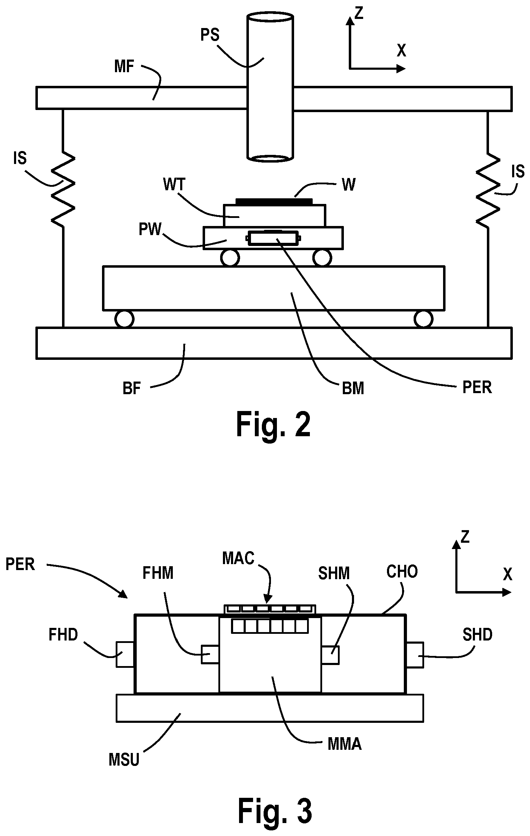

Figure 2 shows a more detailed view of a part of the lithographic apparatus LA of Figure 1. The lithographic apparatus LA may be provided with a base frame BF, a balance mass BM, a metrology frame MF and a vibration isolation system IS. The metrology frame MF supports the projection system PS. Additionally, the metrology frame MF may support a part of the position measurement system PMS. The metrology frame MF is supported by the base frame BF via the vibration isolation system IS. The vibration isolation system IS is arranged to prevent or reduce vibrations from propagating from the base frame BF to the metrology frame MF.

The second positioner PW is arranged to accelerate the substrate support WT by providing a driving force between the substrate support WT and the balance mass BM. The driving force accelerates the substrate support WT in a desired direction. Due to the conservation of momentum, the driving force is also applied to the balance mass BM with equal magnitude, but at a direction opposite to the desired direction. Typically, the mass of the balance mass BM is significantly larger than the masses of the moving part of the second positioner PW and the substrate support WT.

In an embodiment, the second positioner PW is supported by the balance mass BM. For example, wherein the second positioner PW comprises a planar motor to levitate the substrate support WT above the balance mass BM. In another embodiment, the second positioner PW is supported by the base frame BF. For example, wherein the second positioner PW comprises a linear motor and wherein the second positioner PW comprises a bearing, like a gas bearing, to levitate the substrate support WT above the base frame BF.

The position measurement system PMS may comprise any type of sensor that is suitable to determine a position of the substrate support WT. The position measurement system PMS may comprise any type of sensor that is suitable to determine a position of the mask support MT. The sensor may be an optical sensor such as an interferometer or an encoder. The position measurement system PMS may comprise a combined system of an interferometer and an encoder. The sensor may be another type of sensor, such as a magnetic sensor. a capacitive sensor or an inductive sensor. The position measurement system PMS may determine the position relative to a reference, for example the metrology frame MF or the projection system PS. The position measurement system PMS may determine the position of the substrate table WT and/or the mask support MT by measuring the position or by measuring a time derivative of the position, such as velocity or acceleration.

The position measurement system PMS may comprise an encoder system. An encoder system is known from for example, United States patent application US2007/0058173A1, filed on September 7, 2006, hereby incorporated by reference. The encoder system comprises an encoder head, a grating and a sensor. The encoder system may receive a primary radiation beam and a secondary radiation beam. Both the primary radiation beam as well as the secondary radiation beam originate from the same radiation beam, i.e., the original radiation beam. At least one of the primary radiation beam and the secondary radiation beam is created by diffracting the original radiation beam with the grating. If both the primary radiation beam and the secondary radiation beam are created by diffracting the original radiation beam with the grating, the primary radiation beam needs to have a different diffraction order than the secondary radiation beam. Different diffraction orders are, for example, $+1^{st}$ order, $-1^{st}$ order, $+2^{nd}$ order and $-2^{nd}$ order. The encoder system optically combines the primary radiation beam and the secondary radiation beam into a combined radiation beam. A sensor in the encoder head determines a phase or phase difference of the combined radiation beam. The sensor generates a signal based on the phase or phase difference. The signal is representative of a position of the encoder head relative to the grating. One of the encoder head and the grating may be arranged on the substrate structure WT. The other of the encoder head and the grating may be arranged on the metrology frame MF or the base frame BF. For example, a plurality of encoder heads are arranged on the metrology frame MF, whereas a grating is arranged on a top surface of the substrate support WT. In another example, a grating is arranged on a bottom surface of the substrate support WT, and an encoder head is arranged below the substrate support WT.

The position measurement system PMS may comprise an interferometer system. An interferometer system is known from, for example, United States patent US6,020,964, filed on July 13, 1998, hereby incorporated by reference. The interferometer system may comprise a beam splitter, a mirror, a reference mirror and a sensor. A radiation beam is split by the beam splitter into a reference beam and a measurement beam. The measurement beam propagates to the mirror and is reflected by the mirror back to the beam splitter. The reference beam propagates to the reference mirror and is reflected by the reference mirror back to the beam splitter. At the beam splitter, the measurement beam and the reference beam are combined into a combined radiation beam. The combined radiation beam is incident on the sensor. The sensor determines a phase or a frequency of the combined radiation beam. The sensor generates a signal based on the phase or the frequency. The signal is representative of a displacement of the mirror. In an embodiment, the mirror is connected to the substrate support WT. The reference mirror may be connected to the metrology frame MF. In an embodiment, the measurement beam and the reference beam are combined into a combined radiation beam by an additional optical component instead of the beam splitter.

The first positioner PM may comprise a long-stroke module and a short-stroke module. The short-stroke module is arranged to move the mask support MT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the first positioner PM is able to move the mask support MT relative to the projection system PS with a high accuracy over a large range of movement. Similarly, the second positioner PW may comprise a long-stroke module and a short-stroke module. The short-stroke module is arranged to move the substrate support WT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the second positioner PW is able to move the substrate support WT relative to the projection system PS with a high accuracy over a large range of movement.

The first positioner PM and the second positioner PW each are provided with an actuator to move respectively the mask support MT and the substrate support WT. The actuator may be a linear actuator to provide a driving force along a single axis, for example the y-axis. Multiple linear actuators may be applied to provide driving forces along multiple axis. The actuator may be a planar actuator to provide a driving force along multiple axis. For example, the planar actuator may be arranged to move the substrate support WT in 6 degrees of freedom. The actuator may be an electro-magnetic actuator comprising at least one coil and at least one magnet. The actuator is arranged to move the at least one coil relative to the at least one magnet by applying an electrical current to the at least one coil. The actuator may be a moving-magnet type actuator, which has the at least one magnet coupled to the substrate support WT respectively to the mask support MT. The actuator may be a moving-coil type actuator which has the at least one coil coupled to the substrate support WT respectively to the mask support MT. The actuator may be a voice-coil actuator, a reluctance actuator, a Lorentz-actuator or a piezo-actuator, or any other suitable actuator.

In practice, there may be a limit on the acceleration that can be provided by the electro-magnetic actuators of the actuator assembly. Increased acceleration would typically need more space for coils and/or magnets of the actuator assembly. This space is not always available. Furthermore, increased acceleration also requires substantial additional costs in required electrical power.

According to the present disclosure, a potential energy release device PER is provided. The potential energy release device PER may be connected to a movable support and may be configured to release potential energy during acceleration of the movable support. For example, in the embodiment of Figure 2, a potential energy release device PER is connected to the second positioner PW in order to increase acceleration of the substrate support WT and the substrate W supported thereon. In the shown embodiment, the potential energy release device PER may in particular be connected to the long-stroke module of the second positioner PW. This long-stroke module of the second positioner PW will hereinafter also be referred to as the movable support MSU.

During acceleration of the substrate support WT using one or more electro-magnetic actuators of the second positioner PW, the potential energy stored in the potential energy release device PER may simultaneously be released. This potential energy will exert a potential energy based driving force on the movable support MSU. As a result, the potential energy stored in the potential energy release device PER will be converted into kinetic energy during acceleration of the movable support MSU. This will increase the acceleration of the movable MSU compared to the acceleration of the substrate support WT that is obtained with only the one or more electro-magnetic actuators of the second positioner PW.

Fig. 3 shows schematically a cross-section of the potential energy release device PER. The potential energy release device PER comprises a closed cylindrical housing CHO. In the cylindrical housing CHO a movable mass MMA is arranged. The space at opposite sides of the movable mass MMA may be filled with gas. The gas is for example an inert gas, such as argon or nitrogen. The movable mass MMA has an outer cylindrical surface substantially corresponding to an inner surface of the cylindrical housing CHO. The movable mass MMA acts as a piston-like element movable within the closed cylindrical housing CHO and the cylindrical housing CHO functions as a guiding device configured to guide the movable mass MMA along a displacement path extending in x-direction.

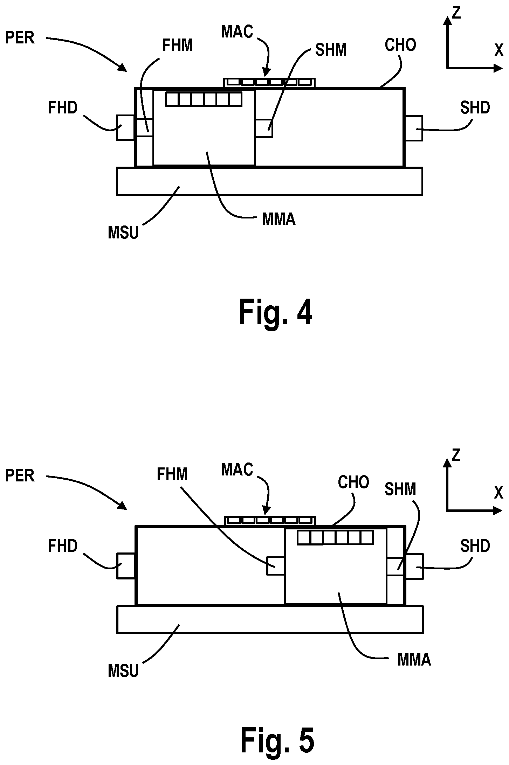

The displacement path defines a first end position of the movable mass MMA in the cylindrical housing CHO (see Fig. 4) and a second end position of the movable mass MMA in the cylindrical housing CHO (See Fig. 5). The movable mass MMA is movable between these first and second end positions. As the cylindrical housing CHO is closed, gas introduced in the interior of the cylindrical housing CHO will be compressed or decompressed due to movement of the movable mass MMA between the first and second end positions.

The potential energy release device PER comprises a first holding device FHD to hold the movable mass MMA in the first end position. The first holding device FHD comprises a first holding coil mounted on the cylindrical housing CHO. The first holding coil is arranged to, when activated, pull a first holding magnet FHM mounted on the movable mass MMA towards the first end position. The potential energy release device PER further comprises a second holding device SHD to hold the movable mass MMA in the second end position.

The second holding device SHD comprises a second holding coil mounted on the cylindrical housing CHO. The second holding coil is arranged to, when activated, pull a second holding magnet FHM mounted on the movable mass MMA towards the second end position.

The first holding device FHD and the second holding device SHD are for example reluctance force actuators.

Fig. 3 shows a neutral position of the movable mass MMA in which the gas pressure at opposite sides is equal. The spaces in the closed cylindrical housing CHO at opposite sides of the movable mass MMA function as gas springs. When the movable mass MMA is moved to the first end position, as shown in Fig. 4, gas at the left side of the movable mass MMA will be compressed and gas at the right side of the movable mass MMA will be decompressed compared with the gas in the neutral position. As a result, the gas in the cylindrical housing CHO will push the movable mass MMA towards the neutral position. Correspondingly, when the movable mass MMA is moved to the second end position, as shown in Fig. 5, gas at the right side of the movable mass MMA will be compressed and gas at the left side of the movable mass MMA will be decompressed compared with the gas in the neutral position. As a result, the gas in the cylindrical housing CHO will push the movable mass MMA towards the neutral position.

The holding forces that can be provided by the first holding device FHD and the second holding device SHD exceed the potential energy based forces provided by the compressed and/or decompressed gas in the cylindrical housing CHO with the movable mass MMA in the first end position or second end position, respectively. This enables the first holding device FHD, when activated, to hold the movable mass MMA in the first end position and the second holding device SHD, when activated, to hold the movable mass MMA in the second end position even though the movable mass MMA is pushed back towards the neutral position.

The potential energy release device PER therewith provides a first potential energy storage associated with the first end position, shown in Fig. 4, and a second potential energy storage associated with the second end position, shown in Fig. 5. The potential energy stored in the first potential energy storage or second potential energy storage can be released by deactivating the first holding device FHD or second holding device SHD, respectively.

An advantage of the embodiment of Fig. 3 is that all moving parts, in particular movable mass MMA and the gas springs are located within the closed housing CHO. This allows the potential energy release device PER to be applied in a vacuum environment, and there is no cross-contamination between the interior of the closed housing CHO and the exterior of the closed housing CHO.

A movable mass actuator MAC is provided to move the movable mass MMA from the neutral position shown in Fig. 3 to one of the first and second end positions against the forces exerted by the compressed and decompressed gas on the movable mass MMA. The movable mass actuator MAC for example comprise an array of coils mounted on the cylindrical housing CHO and an array of permanent magnets mounted on the movable mass MMA. To reach the first end position or the second end position, it may be required to drive the movable mass in an oscillating movement to overcome the force resulting from increasing and decreasing gas pressure at opposite sides of the movable mass MMA.

Since the cylindrical housing CHO is connected to the movable support MSU, for example mounted on the long-stroke module of the movable support MSU, release of the movable mass MMA from the first end position or the second end position, will result in a potential energy based driving force on the movable support MSU in the corresponding x-direction. This potential energy based driving force can be used during acceleration of the movable support MSU in x-direction to increase acceleration of the movable support MSU in this x-direction.

Correspondingly, during deceleration of the movable support MSU in x-direction, the kinetic energy of the movable support MSU can be converted into potential energy by movement of the movable mass MMA. This potential energy can be stored by holding the movable mass MMA in the respective first or second end position of the movable mass MMA by activation of the first holding device FHD or the second holding device SHD, respectively. During conversion of the kinetic energy into potential energy, a potential energy based (negative) driving force will be exerted on the movable support MSU. This potential energy based driving force can be used during deceleration of the movable support MSU in x-direction to decrease the required actuator driving force used for deceleration in this x-direction.

The potential energy release device PER can advantageously be used for a step movement of a movable support MSU. Such step movement may for example be used in a lithographic process in which a patterned radiation beam is projected on exposure fields on a substrate.

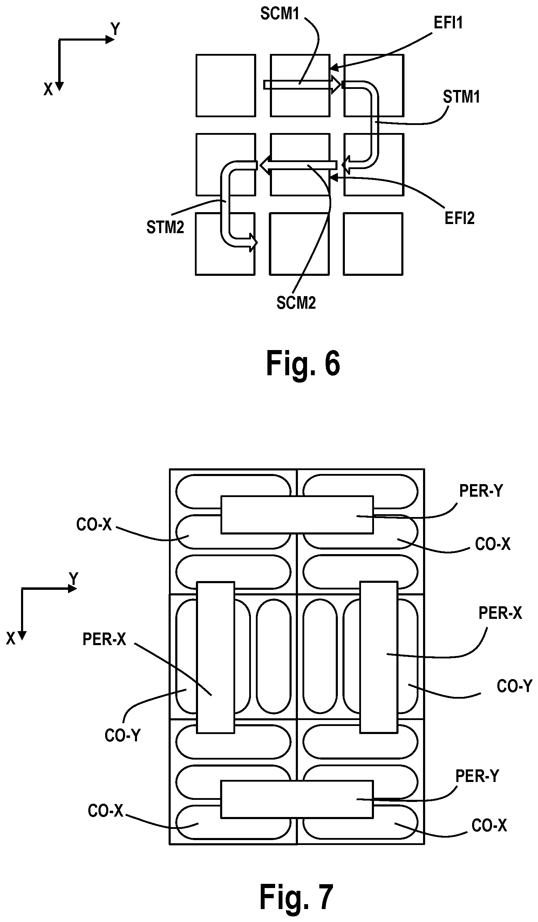

Fig. 6 shows an example of subsequent movements of the movable support MSU during projection of a patterned radiation beam on a substrate. A first scanning movement SCM1 in a scanning direction, e.g. the (positive) y-direction, is made to project the patterned radiation beam on a first exposure field EFI1. After the patterned radiation beam is projected with the first scanning movement SCM1 on the first exposure field EFI1, a step movement STM1 is made in a step direction perpendicular to the scanning direction, e.g. in the x-direction, to align the patterned radiation beam with a second exposure field EFI2 of the substrate W, the second exposure field EFI2 being spaced in x-direction from the first exposure field EFI1. During the step movement STM1 in x-direction, the direction of movement in the scanning direction is reversed, e.g. from positive y-direction to negative y-direction. After the step movement STM1 in x-direction a second scanning movement SCM2 can be made in the scanning direction, e.g. the (negative) y-direction, to project the patterned radiation beam on the second exposure field EFI2. After the second scanning movement SCM2, a second step movement STM2 can be made to align the patterned radiation beam with a subsequent exposure field of the substrate W, the subsequent exposure field being spaced in x-direction from the second exposure field EFI. This combination of scanning movements and step movements can be repeated until the patterned radiation beam is projected on all desired exposure fields.

During the first step movement STM1 a predetermined distance between the first exposure fields EFI1 and the second exposure field EFI2 has to be bridged as quickly as possible. The same distance will normally be bridged between subsequent exposure fields, for example in the second step movement STM2. By adapting the length of the displacement path of the potential energy release device PER between the first holding position and the second holding position to a distance to be bridged during the step movement STM1, the movement of the movable mass MMA may be used to improve the movement of the movable support MSU during the step movement. The distance between the first holding position and the second holding position will typically correspond to the distance bridged during a step movement in step direction, e.g. x-direction, multiplied with the ratio between the mass of the movable support MSU and the mass of the movable mass MMA:

$$D_{displacement\ path} = D_{step\ movement} * M_{MSU}/M_{MMA.}$$

The potential energy release device PER can be used to create an increased acceleration and deceleration of the movable support MSU in the step direction. During this step movement, the movable mass MMA may, for example, move from the first end position to the second end position to exert a potential energy based driving force on the movable support MSU. It is noted that, when it is desired to use the potential energy release device PER during a subsequent step movement in the same direction, for example the second step movement STM2, the movable mass MMA has to be brought back to the first end position in order to allow the potential energy release device PER to provide a potential energy based driving force during the subsequent step movement. This return movement back to the original position may for example be controlled by the movable mass actuator MAC. Any forces exerted by the potential energy release device PER on the movable support MSU due to this return movement of the movable mass MMA, may for example be compensated by the actuators of the second positioner PW, e.g. actuators of the long-stroke module.

The concept of the potential energy release device PER can also be used in acceleration and deceleration of the movable support MSU in the scanning direction, e.g. y-direction, to reverse the direction of movement of the movable support MSU in y-direction. The potential energy based driving force of the potential energy release device PER can be used to increase deceleration of the movable support MSU at the end of the scanning movement and to increase acceleration of the movable support MSU at the beginning of the subsequent scanning movement.

Thus, both in the scanning direction and the step direction energy release devices PER may be provided to improve acceleration and/or deceleration of the movable support MSU of a lithographic apparatus.

Fig. 7 shows schematically an actuator assembly of the long-stroke module of the movable support MSU. The actuator assembly comprises four step coil assemblies CO-X arranged to create an actuator based driving force in x-direction and two scanning coil assemblies CO-Y arranged to create an actuator based driving force in y-direction. The step coil assemblies CO-X and scanning coil assemblies CO-Y cooperate with a permanent magnet plate arranged on the balance mass BM.

The long-stroke module is connected to two potential energy release devices PER-X extending in x-direction and two potential energy release devices PER-Y extending in y-direction. The two potential energy release devices PER-X extending in x-direction cooperate with the four coil assemblies CO-X to exert a combination of a potential energy based driving force and an actuator based driving force in x-direction, for example to execute a step movement with increased acceleration and deceleration. Correspondingly, the two potential energy release devices PER-Y extending in y-direction cooperate with the two coil assemblies CO-Y to exert a combination of a potential energy based driving force and an actuator based driving force in y-direction, for example to start a scanning movement with increased acceleration and end a scanning movement with increased deceleration.

Advantageously, the potential energy based driving force provided by the potential energy release devices PER-X in the x-direction, may be adapted, as far as possible, to match the desired driving force needed for acceleration of the movable support MSU in x-direction. The actuator based driving force in x-direction can be used to adjust the combined driving force to the desired driving force. For example, during acceleration and/or deceleration, at least 60 % of the desired driving force, such as at least 80% of the desired driving force, may be delivered by the potential energy release devices PER-X, while the rest of the required driving force is provided by the four coil assemblies CO-X. The amount of driving force delivered by the potential energy release devices PER-X may vary with the position of the movable mass MMA, as the position of the movable mass MMA determines how much the gas spring is compressed.

Since the actuator based driving force provided by the four coil assemblies CO-X can be accurately controlled by the control system, this actuator based driving force may be relatively adapted to the required driving force. In some positions of the movable mass MMA, for example in the first holding position and/or second holding position, the force provided by the potential energy release devices PER-X may be even higher than the desired driving force. In these positions, the four coil assemblies CO-X may be used to exert a counter force on the movable support MSU in order to exert the desired combined driving force on the movable support MSU.

Correspondingly, the potential energy based driving force provided by the potential energy release devices PER-Y in the y-direction, may be adapted, as far as possible, to match the desired driving force needed for acceleration of the movable support MSU in y-direction. The actuator based driving force provided by the two coil assemblies CO-Y in y-direction can be used to adjust the combined driving force to the desired driving force, since the two coil assemblies CO-Y can be controlled by the control system with high accuracy.

Also in other applications of the potential energy release device PER, the potential energy based driving force provided by the potential energy release device PER, may be adapted, as far as possible, to match the desired driving force needed for acceleration and/or deceleration of the movable support MSU and the actuator based driving force can be used to adjust the combined driving force to the desired driving force.

Another application in which a potential energy release device PER may be applied is in the acceleration and deceleration of a patterning device supported by the first positioner PM (See Fig. 1). During the scanning movement of the substrate, the patterning device MA may be moved in a scanning movement for each exposure field. After each scanning movement of the pattering device MA the speed of the scanning device MA should be reversed. To reverse the speed from the scanning device MA, the potential energy based driving force of the potential energy release device PER may be used to create increased deceleration and acceleration of the patterning device MA.

In applications of the potential energy release device PER to reverse direction of movement of a mass, such as the reversal of motion of the movable support MSU in scanning direction, e.g. y-direction, and the reversal of motion of the patterning device supported by the first positioner PM, the potential energy release device PER may be configured to provide a relatively flat and small driving force in the middle part of the displacement path, associated with the scanning motion with constant speed, and to provide a larger driving force in the parts of the displacement path close to the first and second end positions due to the compression of the gas in the potential energy release device PER.

Further, the potential energy release device PER may be configured to have a motion of the movable mass MMA in antiphase with the desired reversal of motion of the movable support MSU or patterning device. This may be realized with a relatively small movable mass MMA moving over a relatively large displacement path compared to the mass and displacement path of the movable support MSU or patterning device and associated support.

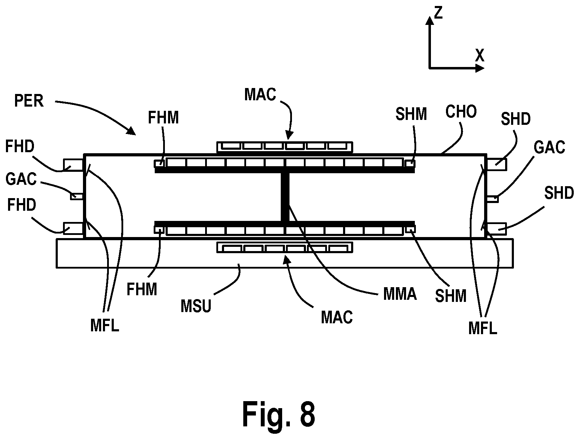

Fig. 8 shows another embodiment of a potential energy release device PER. This potential energy release device PER is similar to the embodiment of Fig. 3. The potential energy release device PER comprises a closed cylindrical housing CHO. In the cylindrical housing CHO a movable mass MMA is arranged. The space at opposite sides of the movable mass MMA may be filled with gas. The gas is for example an inert gas, such as argon or nitrogen. The movable mass MMA is shaped, in cross-section, as a H-shaped profile. The movable mass MMA is movable between a first end position and a second end position.

A first holding device FHD is provided to hold the movable mass MMA in the first en position and a second holding device SHD is provided to hold the movable mass MMA in the second end position. The first holding device FHD may hold the movable mass MMA by exerting a pulling force on a first holding magnet FHD mounted on the movable mass MMA. Similarly, the second holding device SHD may hold the movable mass MMA by exerting a pulling force on a second holding magnet SHD mounted on the opposite side of the movable mass MMA.

A movable mass actuator MAC is provided to move the movable mass MMA from the neutral position shown in Fig. 8 to one of the first and second end positions against the forces exerted by the compressed and decompressed gas on the movable mass MMA. The movable mass actuator MAC for example comprise an array of coils mounted on the cylindrical housing CHO and an array of permanent magnets mounted on the movable mass MMA. To reach the first end position or the second end position, it may be required to drive the movable mass MMA in an oscillating movement to overcome the force resulting from increasing and decreasing gas pressure at opposite sides of the movable mass MMA.

When the first holding device FHD or second holding device SHD is deactivated and the movable mass MMA is released, a relatively large force created by the gas springs directly acts on the movable mass. Such direct force exerted on the movable mass MMA may be undesirable from control perspective. For example, this force may be larger than desired. To create a more soft release from the first end position or second end position, a flexure MFL made of magnetic material is provided at the first end position and the second end position. The flexures MFL may for example be connected to the first holding device FHD and second holding device SHD, respectively.

In addition or as an alternative, the movable mass actuator MAC may be used to adjust the movement of the movable mass MMA and therewith the magnitude, speed and timing of the potential energy based driving force exerted on the movable support MSU.

In order to adjust the quantity of gas in the closed cylindrical housing CHO at opposite sides of the movable mass MMA, gas connections GAC may be provided at suitable locations in the closed housing CHO. The gas connections GAC may also be used to influence the movement of the movable mass MMA in the closed housing CHO, for example by actively controlling the pressure in the closed housing using valves or throttles or by connecting the gas connections to a passive damping device, for example a bellows.

It may also be beneficial to provide position sensors, for example Hall sensors, that are arranged to determine a position of the movable mass MMA with respect to the closed housing. Such measured position can for example be used during active adjustment of the position of the movable mass MMA using the movable mass actuator MAC.

The potential energy release device PER of Fig. 8 may be applied in similar applications as described with respect to the embodiment of Fig. 3.

Hereinabove, potential energy release devices have been described to provide a potential energy based driving force to improve acceleration of a movable object, for example a movable support. The same principle may also be applied in other embodiments. For example, in alternative embodiments, mechanical springs or other potential energy storages may be used instead of gas springs.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1.  A positioning system for positioning an object, the positioning system comprising:

    a movable support to support the object,
    one or more actuators to exert a driving force on the movable support,
    a control system to control the one or more actuators to move the movable support towards a desired position, and
    a potential energy release device connected to the movable support and configured to release potential energy during acceleration of the movable support to increase acceleration of the movable support.

2.  The positioning system of claim 1, wherein the potential energy release device is configured to convert kinetic energy of the movable support into potential energy and store this potential energy during deceleration of the movable support.

3.  The positioning system of claim 1 or 2, wherein the potential energy release device comprises:

    a movable mass,

    a guiding device configured to guide the movable mass along a displacement path, and
    at least one potential energy storage.

4.  The positioning system of claim 3, wherein the potential energy storage comprises a spring or a gas spring.

5.  The positioning system of claim 3 or 4, wherein the displacement path defines a first end position and a second end position, wherein the movable mass is movable between the first end position and the second end position.

6.  The positioning system of claim 5, wherein the at least one potential energy release device comprises a first holding device to hold the movable mass in the first end position and a second holding device to hold the movable mass in the second end position.

7.  The positioning system of claim 5 or 6, wherein the potential energy release device comprises a first potential energy storage associated with the first end position and a second potential energy storage associated with the second end position.

8.  The positioning system of any of the claims 5-7, wherein the potential energy release device comprises an actuator to move the movable mass into the first end position and/or into the second end position.

9.  The positioning system of any of the claims 3-8, wherein the guiding device comprises a closed cylindrical tube in which the movable mass is arranged in a piston like manner, such that a space between the movable mass and one of the closed ends of the cylindrical tube forms a gas spring to be used as the at least one potential energy storage.

10. The positioning system of any of the preceding claims, wherein the positioning system comprises one or more actuators to exert a first driving force on the movable support in a first driving direction and one or more further actuators to exert a second driving force on the movable support in a second driving direction, wherein the first driving direction is orthogonal to the second driving direction, wherein the potential energy release device is connected to the movable support and configured to release potential energy during acceleration of the movable support in the first driving direction.

11. The positioning system of claim 10, wherein the positioning system comprises a further potential energy release device connected to the movable support and configured to release potential energy during acceleration of the movable support in the first driving direction or in the second driving direction.

12. The positioning system of any of the preceding claims, wherein the movable support comprises a long-stroke module and a short-stroke module, wherein the short-stroke module is movably supported on the long-stroke module, wherein the short-stroke module is arranged to support the object and wherein the potential energy release device is connected to the long-stroke module.

13. A lithographic apparatus comprising the positioning system of any of the preceding claims to position an object.

14. The lithographic apparatus of claim 13, wherein the object is a substrate or a patterning device.

15. A method to drive a movable support of a positioning system,
wherein the method comprises accelerating the movable support by:

exerting a potential energy based driving force on the movable support using a potential energy release device, and
simultaneously exerting an actuator based driving force on the movable support using one or more actuators.

16. The method of claim 15, wherein the method comprises decelerating the movable support by:

storing potential energy obtained from kinetic energy of the movable support in at least one potential energy storage of the potential energy release device, and
simultaneously exerting an actuator based driving force on the movable support using one or more actuators.

17. A method comprising projecting a patterned radiation beam onto a substrate, comprising

supporting the substrate by the movable support of the positioning system of any of the claims 1-12,
moving the movable support during a scanning movement in a scanning direction to project the patterned radiation beam onto a first exposure field of the substrate,
moving the movable support during a step movement between two scanning movements in a step direction to align the patterned radiation beam with a second exposure field of the substrate, which second exposure field is spaced from the first exposure field in the step direction, wherein the method further comprises:

releasing potential energy stored in the potential energy release device for acceleration of the movable support in the scanning direction during beginning of the scanning movement of the movable support, and/or releasing potential energy stored in the potential energy release device for acceleration of the movable support in the step direction during beginning of the step movement of the movable support.

18. The method of claim 17, further comprising:

storing potential energy obtained from kinetic energy of the movable support in at least one potential energy storage of the potential energy release device during deceleration of the movable support in the scanning direction, and/or storing potential energy obtained from kinetic energy of the movable support in at least one potential energy storage of the potential energy release device during deceleration of the movable support in the step direction

**Fig. 1**

**Fig. 2**

**Fig. 3**

Fig. 4

Fig. 5

Fig. 6

Fig. 7

**Fig. 8**

Europäisches
Patentamt
European
Patent Office
Office européen
des brevets

# EUROPEAN SEARCH REPORT

**Application Number**

EP 24 20 9340

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 9 298 106 B1 (UMMETHALA ET AL) 29 March 2016 (2016-03-29) | 15 | INV. G03F7/20 G03F7/00 |
| A | * column 6, lines 35-60 * * figures 1, 2 * | 1-14 | |
| X | EP 3 107 195 A1 (INDRIVETEC) 21 December 2016 (2016-12-21) | 15 | |
| A | * paragraphs [0037] - [0039] * * figures 1-6 * | 1-14 | |
| X | CN 109 690 407 B (ASML) 13 August 2021 (2021-08-13) | 15 | |
| A | * figures 1, 2, 5 * | 1-14 | |

**TECHNICAL FIELDS SEARCHED (IPC)**

G03F

The present search report has been drawn up for all claims

| Place of search | Date of completion of the search | Examiner |
|---|---|---|
| Munich | 1 July 2025 | Subke, Kai-Olaf |

EPO FORM 1503 03.82 (P04C01)

## ANNEX TO THE EUROPEAN SEARCH REPORT
## ON EUROPEAN PATENT APPLICATION NO.

EP 24 20 9340

This annex lists the patent family members relating to the patent documents cited in the above-mentioned European search report.
The members are as contained in the European Patent Office EDP file on
The European Patent Office is in no way liable for these particulars which are merely given for the purpose of information.

01-07-2025

| Patent document cited in search report | | Publication date | Patent family member(s) | | Publication date |
|---|---|---|---|---|---|
| US 9298106 | B1 | 29-03-2016 | NONE | | |
| EP 3107195 | A1 | 21-12-2016 | CN | 107925339 A | 17-04-2018 |
| | | | CN | 114465420 A | 10-05-2022 |
| | | | EP | 3107195 A1 | 21-12-2016 |
| | | | EP | 3311473 A1 | 25-04-2018 |
| | | | EP | 3595149 A1 | 15-01-2020 |
| | | | HK | 1253330 A1 | 14-06-2019 |
| | | | US | 2018159416 A1 | 07-06-2018 |
| | | | WO | 2016202798 A1 | 22-12-2016 |
| CN 109690407 | B | 13-08-2021 | CN | 109690407 A | 26-04-2019 |
| | | | JP | 6845305 B2 | 17-03-2021 |
| | | | JP | 2019532324 A | 07-11-2019 |
| | | | KR | 20190047037 A | 07-05-2019 |
| | | | NL | 2019468 A | 15-03-2018 |
| | | | US | 2019219932 A1 | 18-07-2019 |
| | | | WO | 2018050443 A1 | 22-03-2018 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 20070058173 A1
- US 6020964 A